(19) Europäisches Patentamt / European Patent Office / Office européen des brevets

(11) **EP 2 020 631 A2**

(12) # EUROPEAN PATENT APPLICATION

(43) Date of publication:
**04.02.2009 Bulletin 2009/06**

(51) Int Cl.:
***G06F 3/044*** *(2006.01)*     ***H03K 17/96*** *(2006.01)*

(21) Application number: **08252606.2**

(22) Date of filing: **31.07.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.08.2007 JP 2007200344**

(71) Applicant: **Hosiden Corporation**
**Yao-shi, Osaka 581-0071 (JP)**

(72) Inventors:
• **Toyota, Naoki**
  **Hosiden Corporation**
  **Osaka 581-0071 (JP)**
• **Nakagawa, Hiroshi**
  **Hosiden Corporation**
  **Osaka 581-0071 (JP)**

(74) Representative: **Beresford, Keith Denis Lewis et al**
  **BERESFORD & Co.**
  **16 High Holborn**
  **London**
  **WC1V 6BX (GB)**

(54) **Touch panel input device**

(57)     A touch panel input device includes a plurality of sensor electrodes 200 disposed in planar spaced relation; and a nonconductive member or spacer 300 to be placed on the sensor electrodes 200. In response to an approaching finger, electrostatic capacitance between the respective sensor electrodes 200 and the finger varies. The spacer 300 has a plurality of first blocks 310 adapted to contact with the plurality of sensor electrodes 200; and a plurality of second blocks 320 provided between the first blocks 310. The second blocks 320 have a lower permittivity than that of the first blocks 310. The touch panel input device reduces occurrence of false inputs due to electrostatic capacitance variations at sensor electrodes adjacent to a desired sensor electrode.

**FIG. 2**

EP 2 020 631 A2

## Description

The present invention relates to a touch panel input device used as an input device for receiving input operations in an electronic apparatus or the like.

In a touch panel input device of this type, in response to an approaching finger, electrostatic capacitance between a plurality of sensor electrodes and the finger varies. See for example Japanese Unexamined Patent Publication No. 2000-165223.

Each of the sensor electrodes preferably has as large an area as possible in order to have an adequate degree of sensitivity.

However, in a case where the sensor electrodes are disposed in a small region, increase in area of the sensor electrodes causes decrease in pitch distance between the sensor electrodes. When the pitch distance is decreased between the sensor electrodes, in response to an approaching finger, electrostatic capacitance variations may occur not only to a sensor electrode desired to sense the approaching finger but also to a sensor electrode adjacent to the desired sensor electrode. As a result, a false input may occur due to an electrostatic capacitance variation with respect to a sensor electrode adjacent to the desired sensor electrode.

The present invention is made in view of the circumstance described above. An embodiment of the invention provides a touch panel input device with reduced occurrences of false inputs due to electrostatic capacitance variations with respect to sensor electrodes adjacent to a desired sensor electrode.

In order to solve the above problem, in a touch panel input device according to the present invention, in response to an approaching finger, electrostatic capacitance between each of a plurality of sensor electrodes and the finger varies, and the input device includes a plurality of sensor electrodes disposed in planar spaced relation and a nonconductive member. The nonconductive member includes a plurality of first blocks adapted to contact respective ones of the sensor electrodes, the plurality of first blocks having a first relative permittivity and being separated by areas having a second relative permittivity lower than the first relative permittivity.

Preferably, the areas between said first blocks comprise air. The nonconductive member may be integrally provided in an operation panel or a housing.

In another aspect, the invention provides a touch panel input device in which, in response to an approaching finger, electrostatic capacitance between each of a plurality of sensor electrodes and the finger varies, and the input device includes a plurality of sensor electrodes disposed planarly in spaced relation, and a nonconductive member to be placed on the sensor electrodes. The nonconductive member includes a plurality of first blocks adapted to contact with at least associated central parts of the sensor electrodes, and a plurality of second blocks provided between the first blocks. The second blocks have a lower permittivity than that of the first blocks.

In such a touch panel input device, in response to a finger approaching one of the first blocks, the electrostatic capacitance changes significantly with respect to the sensor electrode in contact with the first block. On the other hand, the electrostatic capacitance change is small between a sensor electrode adjacent to the relevant sensor electrode and the finger. The reason is, between the adjacent sensor electrode and the finger, there exists a second block disposed adjacent to the relevant first block and this second block has a lower permittivity than that of the first block. Therefore, the input device of the invention can suppress occurrences of false inputs due to electrostatic capacitance variations with respect to the adjacent sensor electrode, by sensing only electrostatic capacitance variations exceeding a predetermined amount.

In another touch panel input device according to the present invention, in response to an approaching finger, electrostatic capacitance between each of a plurality of sensor electrodes and the finger varies, and the input device includes a plurality of sensor electrodes disposed planarly in spaced relation and a plurality of nonconductive members to be placed on at least associated central parts of the plurality of sensor electrodes.

In such a touch panel input device, air gaps are formed respectively between the plurality of nonconductive members which are placed on the plurality of sensor electrodes. The air gaps have a lower permittivity than that of the nonconductive members. Therefore, in response to a finger approaching one of the nonconductive members, the electrostatic capacitance changes significantly with respect to the associated sensor electrode in contact with the nonconductive member. On the other hand, the electrostatic capacitance change is small with respect to a sensor electrode adjacent to the relevant sensor electrode because there is an air gap between the adjacent sensor electrode and the finger. Therefore, the input device of the invention can suppress occurrences of false inputs due to electrostatic capacitance variations with respect to the adjacent sensor electrode, by sensing only electrostatic capacitance variations exceeding a predetermined amount.

Each of the second blocks is preferably provided with a slit. In such a case, the slit in the second block forms an air gap between the first blocks. The air gap has a lower permittivity than that of the nonconductive member. Therefore, in response to a finger approaching one of the first blocks, the electrostatic capacitance changes significantly with respect to the sensor electrode in contact with the relevant first block. On the other hand, the electrostatic capacitance change is small with respect to a sensor electrode adjacent to the relevant sensor electrode because there is an air gap between the adjacent sensor electrode and the finger. Therefore, the input device of the invention can suppress occurrences of false inputs due to electrostatic capacitance variations of the adjacent sensor electrode, by sensing only electrostatic capacitance variations exceeding a predetermined amount.

In still another touch panel input device according to the present invention, in response to an approaching finger, electrostatic capacitance between each of a plurality of sensor electrodes and the finger varies, and the input device includes a plurality of sensor electrodes disposed planarly in spaced relation, and a nonconductive member to be placed on the sensor electrodes. The nonconductive member includes a plurality of first blocks adapted to contact with at least associated central parts of the sensor electrodes, and a plurality of second blocks provided between the first blocks. The second blocks each have a conductive member buried therein, the conductive member being connectable to ground.

In such a touch panel input device, in response to a finger approaching one of the first blocks, the electrostatic capacitance changes significantly with respect to the sensor electrode in contact with the first block. On the other hand, the electrostatic capacitance change is small with respect to a sensor electrode adjacent to the relevant sensor electrode because the adjacent sensor electrode is shielded from the finger by the grounded conductive member. Therefore, the input device of the invention can suppress occurrences of false inputs due to electrostatic capacitance variations of the adjacent sensor electrode, by sensing only electrostatic capacitance variations exceeding a predetermined amount.

The nonconductive member or the nonconductive members can be integrally provided in an operation panel or a housing.

In a case where the touch panel input device further includes an operation panel or a housing to be placed on the nonconductive member or the nonconductive members, the nonconductive members can be formed as a spacer or spacers to be interposed between the operation panel or the housing and the sensor electrodes.

Embodiments of the invention will now be described in detail, by way of example only, with reference to the drawings, in which:

Fig. 1 includes schematically exploded plan view of the touch panel input device according to an embodiment of the present invention;

 Fig. 2 is a schematic cross sectional view of the input device;
 Fig. 3 is a schematic cross sectional view of the input device according to a modification in design;
 Fig. 4 is a schematic cross sectional view of the input device according to another modification in design.

In the description which follows, relative spatial terms such as "upper", "lower", "above", etc., are used for the convenience of the skilled reader and refer to the orientation of the touch panel input device and its constituent parts as depicted in the drawings. No limitation is intended by use of these terms, either in use of the invention, during its manufacture, shipment, custody, or sale, or during assembly of its constituent parts or when incorporated into or combined with other apparatus.

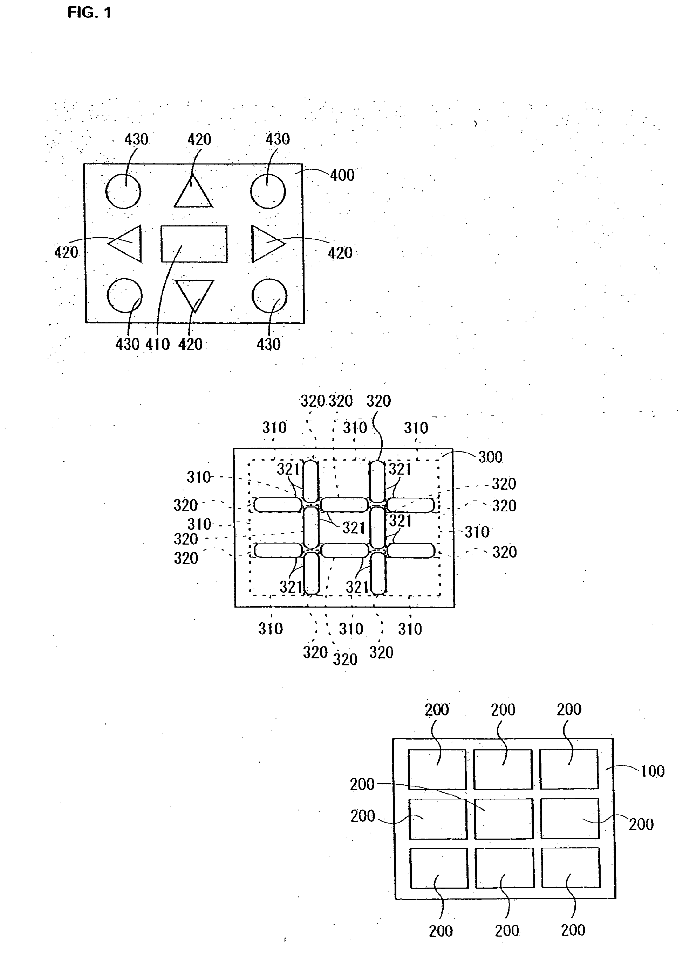

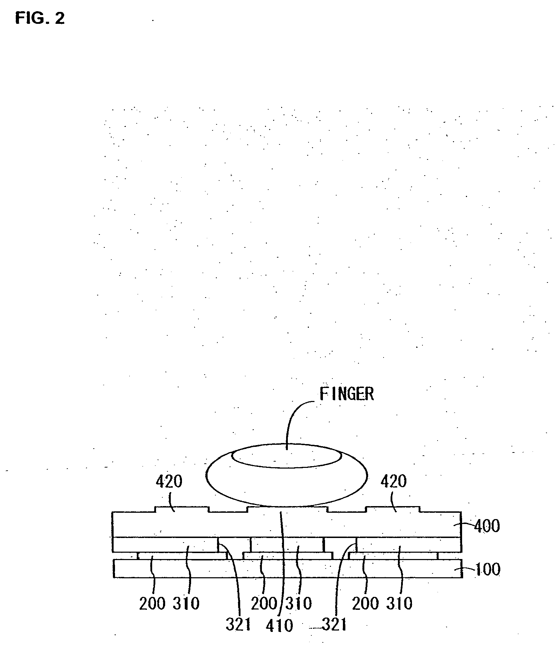

The touch panel input device shown in Figs. 1 and 2 includes a substrate 100, nine sensor electrodes 200 disposed on the substrate 100, a nonconductive spacer 300 placed on the sensor electrodes 200, and an operation panel 400 placed on the spacer 300. The nine sensor electrodes 200 are arranged in spaced relation to form a matrix, and each of the electrodes 200 varies in electrostatic capacitance in response to an approaching finger. The respective parts are described in detail below.

The substrate 100 may be a rigid substrate or a flexible substrate.

The spacer 300 is a plate-like molded article of resin such as polyamide (PA) resin, polycarbonate (PC) resin, polyethylene terephthalate (PET) resin and ABS resin. Resins of these kinds have a relative permittivity of 3 to 4.

The spacer 300 has nine first blocks 310, which respectively have a substantially rectangular shape and are respectively in contact with central parts of the nine sensor electrodes 200, and twelve second blocks 320, which respectively have a substantially rectangular shape and are respectively located between the adjacent first blocks 310.

Each of the second blocks 320 is provided with a slit 321 that is a long hole extending along an end of the adjacent first block 310. Each of the slits 321 forms an air gap between the adjacent first blocks 310. Air in the air gaps has a relative permittivity of 1.

The operation panel 400 is a plate-like molded article of resin such as polyamide (PA) resin, polycarbonate (PC) resin, polyethylene terephthalate (PET) resin and ABS resin. Resins of these kinds also have a relative permittivity of 3 to 4.

The operation panel 400 is provided at the central part of an upper face thereof with a first operational projection 410 in a substantially rectangular shape. The first operational projection 410 on the operation panel 400 is surrounded alternately by four substantially triangular second operational projection 420 and four substantially circular third operational projections 430. The first operational projection 410, the second operational projections 420, and the third operational projections 430 are arranged respectively on the sensor electrodes 200.

The respective sensor electrodes 200 are copper foils mounted on the substrate 100. When one of the first operational projection 410, second operational projections 420, and third operational projections 430 on the operation panel 400 is approached by or touched with a finger (in other words, when the finger approaches), the electrostatic capacitance is varied between the corresponding sensor electrode 200 and the finger.

The sensor electrodes 200 are connected to a signal processing circuit (not shown) provided on the substrate 100. This signal processing circuit measures amounts of variations in electrostatic capacitance between the respective sensor electrodes 200 and the finger. When a variation in electrostatic capacitance exceeds a predetermined amount, the circuit senses that the finger has touched one of the first operational projection 410, second operational projections 420, and third operational projections 430 on the operation panel 400.

The electrostatic capacitance with respect to each sensor electrodes 200 is obtained by the following equation:

$$ C \;=\; \frac{\varepsilon \;*\; S}{D} $$

where

C = Electrostatic capacitance
e = Permittivity
S = Area of a sensor electrode facing the finger
D = Distance between the finger and a sensor electrode

For example, Fig. 2 illustrates a case where the first operational projection 410 on the operation panel 400 is touched with a finger. The electrostatic capacitance significantly changes between the finger and the sensor electrode 200 disposed below the finger and the first operational projection 410 (i.e., the central sensor electrode 200 in the figure). Such a significant change occurs because the central sensor electrode 200 has a large area (S) facing the finger and is located at a short distance (D) from the finger, and because the first operational projection 410 and the first block 310 disposed therebelow respectively have a relative permittivity ($\varepsilon$) of 3 to 4. By contrast, change in the electrostatic capacitance is relatively small between the finger and the sensor electrodes 200 adjacent to the relevant sensor electrode 200 (specifically, the outer sensor electrodes 200 in the figure). This is because each of these adjacent sensor electrodes 200 has a smaller area (S) facing the finger and is located at a larger distance from the finger, and because the air gap formed between each of the adjacent sensor electrodes 200 and the finger has a relative permittivity ($\varepsilon$) of 1.

In this regard, a conventional touch panel input device only has an operation panel in a plate shape provided on a plurality of sensor electrodes. When such an operational panel was touched with finger, the sensor electrode disposed therebelow is different from the adjacent sensor electrodes in area (S) facing the finger and distance (D) from the finger. However, a permittivity ($\varepsilon$) is the same throughout the operation panel. Accordingly, as a pitch distance is reduced between the sensor electrodes, the degree of electrostatic capacitance changes between the adjacent sensor electrodes and the finger is about the same as the degree between the sensor electrode directly below the finger and the finger.

This is in contrast to the touch panel input device according to the embodiment, even in a case where the pitch distance is small between the sensor electrodes 200. The air gaps described above suppress electrostatic capacitance variations with respect to the sensor electrodes 200 adjacent to the sensor electrode 200 disposed below the touched operational projection of the operation panel 400. Consequently, the signal processing circuit measures a significant change in electrostatic capacitance with respect to the sensor electrode 200 disposed below the touched operational projection to sense that the operational projection located above the sensor electrode 200 is touched. On the other hand, when the signal processing circuit measures a small change in electrostatic capacitance with respect to the adjacent sensor electrodes 200, the circuit does not sense that the operational projection located above each of the adjacent sensor electrodes 200 is toughed. As a result, the touch panel input device according to the embodiment can prevent a false input due to electrostatic capacitance variations with respect to the adjacent sensor electrodes 200.

In the above embodiment, the second blocks 320 are provided with the slits 321 that form the air gaps for holding air, which is dielectric having a permittivity lower than that of the first blocks. However, the present invention is not limited to such a case. Any design modifications may be made to the second blocks as long as they are made of a material having a permittivity lower than that of the first blocks.

Instead of forming the second blocks of a material having a permittivity lower than that of material for the first blocks, each of the second blocks may include a conductive member (metal such as copper, iron and stainless steel) that is buried therein (specifically, by insert molding)and connected to ground. In this case, the adjacent sensor electrodes 200 can be shielded so as not to be affected by electrostatic capacitance variations between the desired sensor electrode 200 and the finger. Such shielding has a similar effect to the air gap.

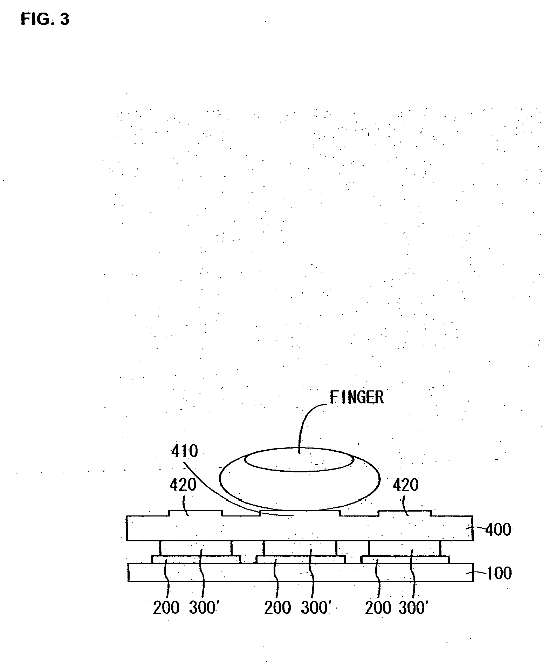

Further, it is described in the above embodiment that the air gap is formed by the slit 321 provided in each of the second blocks 320 which are disposed between the first blocks 310. However, the present invention is not limited to such a case. Alternatively, as shown in Fig. 3, there may be placed a plurality of nonconductive spacers 300' on respective central parts of the plurality of sensor electrodes 200, so that air gaps are formed between the spacers 300'.

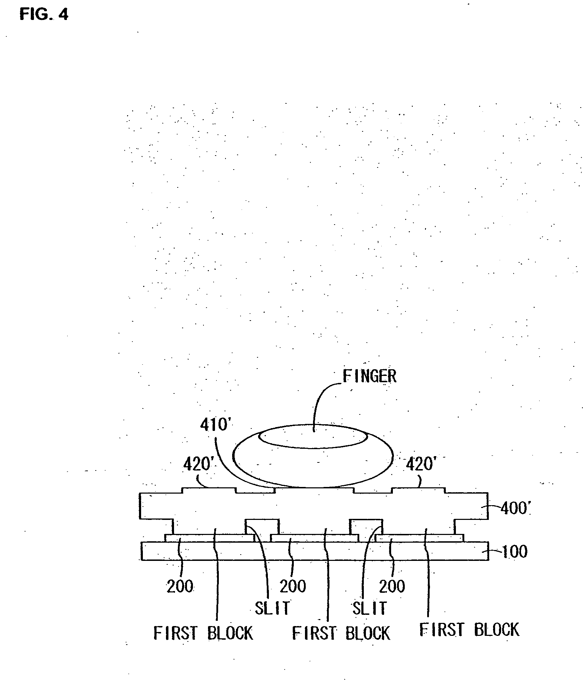

The present invention is not limited to a case where the nonconductive member is the spacer 300 as described in the above embodiment. Alternatively, as shown in Fig. 4, a lower face of an operation panel 400' may form first and second blocks, each of which second blocks is formed with a slit. Further, in a case where the operation panel is provided integrally with a housing of the touch panel input device, the housing may be provided with first and second blocks, each of which second blocks is formed with a slit. Also in these cases, the second blocks may not be provided with slits but may be made of a material having a permittivity lower than that of the material for the first blocks as described above. Obviously, the spacers 300' shown in Fig. 3 may be integrally provided in the operation panel or the housing. Alternatively, the spacers 300' may be attached to a main body of the operation panel or a main body of the housing with adhesive tapes or other means. It is noted that the spacer 300 can be omitted if the operation panel or the housing is utilized as the nonconductive member.

Although it is described above that the operation panel 400 or 400' is provided with the first operational projection 410, second operational projections 420, and third operational projections 430, the present invention is not limited to this case. Alternatively, the operation panel may have a flat operation face. Such a flat operation face is applicable to a case where the operation panel is provided integrally with the housing.

Each of the first blocks 310 should be contactable with at least the central part of the corresponding sensor electrode 200. However, the present invention does not exclude a case where the first block is in contact with an entire face of the sensor electrode 200. It is noted that the central part of the sensor electrode 200 herein is defined as a part except for a peripheral edge of the face of the sensor electrode 200.

The slits 321 may be provided when the spacer, the operation panel, or the housing is molded. Alternatively, the slits 321 may be provided by slit processing after the spacer, the operation panel, or the housing is molded. These options are similarly applicable to a case where the slits are provided in the operation panel or the housing.

Any type of sensor electrodes 200 may be selected as long as electrostatic capacitance with respect to the sensor electrodes 200 varies in response to an approaching finger. For example, electrostatic capacitance between a pair of sensor electrodes may be varied in response to an approaching finger. In this case, the pair of sensor electrodes may be in contact with the associated ones of the first blocks of the nonconductive member, and the air gaps formed between the first blocks may be provided around the pair of sensor electrodes. Alternatively, the pair of sensor electrodes may be in contact with the associated ones of the plurality of nonconductive members, and the air gaps formed between the first blocks may be provided around the pair of sensor electrodes.

The sensor electrodes 200 are not limited to the copper foils as described above, but may be transparent electrodes which are provided on the face of the operation panel. Also in such a case, the first blocks can be defined as parts in contact with the transparent electrodes, and the second blocks can be defined as parts between the adjacent first blocks. It is optional whether to provide the second blocks with slits or to provide the second blocks made of a material having a lower permittivity than that of the material for the first blocks. Further alternatively, the operation panel may be divided into a plurality of parts in contact with the respective transparent electrodes, between which parts air gaps are formed and tapes are used to connect together. In a case where the transparent electrodes are used as the sensor electrodes, provision of the substrate 100 is not required.

Layout of the sensor electrodes 200 is not specifically limited as long as they are planarly disposed so as to be spaced apart from one another. For example, the sensor electrodes 200 can be aligned in one line.

The touch panel input device according to the present invention is applicable to touch panels for mobile communication terminals, vehicle navigation systems, automated teller machines, portable music players, and the like. Further, the respective members of the touch panel input device are not limited to the embodiments described above in terms of materials, the number, shapes and other configurations.

Component List

| | |
|---|---|
| 100 | Substrate |
| 200 | Sensor electrode |
| 300 | Spacer (nonconductive member) |
| 310 | First block |
| 320 | Second block |
| 321 | Slit |
| 400 | 400' Operation panel |

**Claims**

1. A touch panel input device in which, in response to an approaching finger, in use, electrostatic capacitance between each of a plurality of sensor electrodes and the finger varies, the input device comprising:

   a plurality of sensor electrodes (200) disposed in planar spaced relation; and
   a nonconductive member (-300) adapted to be placed on the sensor electrodes, the nonconductive member including:
   a plurality of first blocks (310) adapted to contact at least associated central parts of respective sensor electrodes; and
   a plurality of second blocks (320) provided between the first blocks,
   wherein the second blocks have a lower permittivity than the first blocks.

2. A touch panel input device in which, in response to an approaching finger, in use, electrostatic capacitance between each of a plurality of sensor electrodes and the finger varies, the input device comprising:

> a plurality of sensor electrodes (200) disposed in planar spaced relation; and
> a plurality of nonconductive members (300') adapted to be placed on at least associated central parts of the plurality of sensor electrodes.

3. A touch panel input device in which, in response to an approaching finger, in use, electrostatic capacitance between each of a plurality of sensor electrodes and the finger varies, the input device comprising:

> a plurality of sensor electrodes (200) disposed in planar spaced relation; and
> a nonconductive member (300) adapted to be placed on the sensor electrodes, the nonconductive member including:
> a plurality of first blocks (310) adapted to contact at least associated central parts of respective sensor electrodes; and
> a plurality of second blocks (320) provided between the first blocks,
> wherein the second blocks each have a conductive member buried therein, the conductive member being connectable to ground.

4. The touch panel input device according to claim 1, wherein the second blocks (320) are each provided with a slit (321).

5. The touch panel input device according to claims 1 or 3, wherein
the nonconductive member (300) is integrally provided in an operation panel (400) or a housing.

6. The touch panel input device according to claim 1 or 3, further comprising:

> an operation panel (400) or a housing to be placed on the nonconductive member (300), wherein
> the nonconductive member is a spacer adapted to be interposed between the operation panel or the housing and the sensor electrodes (200).

7. The touch panel input device according to claim 2, wherein
the nonconductive members (300') are integrally provided in an operation panel (400) or a housing.

8. The touch panel input device according to claim 2, further comprising:

> an operation panel (400) or a housing to be placed on the nonconductive members (300'), wherein
the nonconductive members are spacers (300') adapted to be interposed between the operation panel or the housing and the sensor electrodes (200).

9. A touch panel input device in which, in response to an approaching finger, in use, electrostatic capacitance between each of a plurality of sensor electrodes and the finger varies, the input device comprising:

> a plurality of sensor electrodes (200) disposed in planar spaced relation; and
> a nonconductive member (300) including:
> a plurality of first blocks (310) adapted to contact respective ones of the sensor electrodes, said plurality of first blocks having a first relative permittivity and being separated by areas having a second relative permittivity lower than the first relative permittivity.

10. The touch panel input device of claim 9 wherein said areas between said first blocks (310) comprise air.

11. The touch panel input device of claim 9 or claim 10 wherein the nonconductive member (300) is integrally provided in an operation panel (400) or a housing.

**FIG. 1**

FIG. 2

**FIG. 3**

**FIG. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000165223 A